# EUROPÄISCHE PATENTANMELDUNG

(11) **EP 3 312 879 A1**
(43) Veröffentlichungstag der Anmeldung: **25.04.2018**
(21) Anmeldenummer: 16194702.3
(22) Anmeldetag: 20.10.2016
(51) Int. Cl.: H01L 23/427

(54) **KÜHLVORRICHTUNG ZUM KÜHLEN VON IM INNERN EINES GESCHLOSSENEN GEHÄUSES ANGEORDNETEN ELEKTRISCHEN UND/ODER ELEKTRONISCHEN BETRIEBSMITTELN**

(71) Anmelder: Siemens Aktiengesellschaft, 80333 München (DE)
(72) Erfinder: Knauer, Hans, 91359 Leutenbach (DE)

(57) **Zusammenfassung**

Eine Kühlvorrichtung zum Kühlen von im Innern eines geschlossenen Gehäuses (2) angeordneten elektrischen und/oder elektronischen Betriebsmitteln (4,34,36,38) umfasst einem ersten geschlossenen Kühlkreislauf (6). Der erste Kühlkreislauf (6) enthält ein erstes Kühlmedium zum Abtransport von Wärme, die im Betrieb von mindestens einem der Betriebsmittel (4) erzeugt wird, aus dem Gehäuse (2) heraus. Zum ersten Kühlkreislauf (6) gehören ein innerhalb des Gehäuses (2) angeordneter erster Wärmeübertrager (8,18) zum Übertragen der Wärme von dem mindestens einen Betriebsmittel (4) auf das erste Kühlmedium und außerhalb des Gehäuses (2) ein zweiter Wärmeübertrager (14) zum Abgeben der Wärme an ein Außenkühlmedium. Der zweite Wärmeübertrager (14) ist oberhalb des ersten Wärmeübertragers (8,18) angeordnet. Der erste Kühlkreislauf (6), das erste Kühlmedium und der erste und zweite Wärmeübertrager (8,18;14) sind ausgebildet, den Wärmetransport nach dem Zweiphasen-Thermosiphon-Prinzip zu realisieren.

## Beschreibung

Die vorliegende Erfindung betrifft eine Kühlvorrichtung zum Kühlen von im Innern eines geschlossenen Gehäuses angeordneten elektrischen und/oder elektronischen Betriebsmitteln.

Elektrische und elektronische Komponenten einer verfahrenstechnischen Anlage, einer Werkzeugmaschine oder Fertigungseinrichtung, die sich nicht direkt in der Maschine befinden (z. B. Sensoren), sind aus mehreren Gründen in einem eigenen Gehäuse untergebracht. Das Gehäuse soll für die Komponenten in seinem Innenraum unter anderem Schutz vor Staub und Wasser bieten, es soll weiterhin der Halterung und Strukturierung des inneren Aufbaus dienen und es soll die in seinem Innenraum angeordneten Betriebsmittel vor Überhitzung schützen, usw.

Jedoch sind bei Gehäusekonstruktionen für hohe Schutzarten, beispielsweise für Schutzklasse IP 54 oder Schutzklasse IP 65, oder für Anwendungen im Freien, besondere Maßnahmen zur Entwärmung der im Gehäuse angeordneten Betriebsmittel erforderlich.

So sind bei luftgekühlten Gehäusen für hohe Schutzarten Filtereinrichtungen für die Kühlluft vorgesehen, wie beispielsweise in der Luftströmung angeordnete Filtermatten. Damit kann Schutz bis Schutzklasse IP 54 erreicht werden. Nachteilig ist dabei jedoch, dass die Filter regelmäßig gereinigt oder getauscht werden müssen.

Für Anwendungen im Freien findet auch eine so genannte Durchsteckkühlung Verwendung, bei der Betriebsmittel mit hoher Verlustleistung, wie beispielsweise Halbleiterleistungsmodule, direkt mit der Umgebungsluft gekühlt werden. Die Durchsteckkühlung umfasst einen in einer Wandung des Gehäuses angeordneten Kühlkörper. Auf dem Kühlkörper ist innerhalb des Gehäuses das Betriebsmittel montiert, die Kühlrippen des Kühlkörpers sind außerhalb des Gehäuses angeordnet. Dabei muss der Kühlkörper für "unreine" Luft dimensioniert werden, was größere Kühlrippenabstände und somit eine entsprechend große Dimensionierung des Kühlkörpers erforderlich macht. Zudem kann die Reinigung des Kühlkörpers je nach Einbauort und Umgebung des Gehäuses schwierig sein. Die Betriebswärme der übrigen im Gehäuse angeordneten Betriebsmittel muss dann zusätzlich beispielsweise über eine Luftkühlung mit im Luftstrom angeordneten Filtermatten abgeführt werden.

Hohe Verlustleistungen der im Gehäuse angeordneten Betriebsmittel können auch über eine Flüssigkeitskühlung abgeführt werden. Ein Flüssigkeitskühlkreislauf, beispielsweise ein Wasserkreislauf, zur Kühlung ist jedoch nur bei wenigen Anwendungen vorhanden.

Schließlich werden zur Kühlung der im Gehäuse angeordneten Betriebsmittel Klimageräte eingesetzt. Klimageräte müssen jedoch gewartet werden, beispielsweise zum Tausch der Filter, und erfordern zum Betrieb zusätzliche Energie.

Die Aufgabe der vorliegenden Erfindung besteht darin, eine robuste und wartungsarme Kühlvorrichtung von in einem Gehäuse angeordneten elektrischen und/oder elektronischen Betriebsmitteln anzugeben.

Die Aufgabe wird durch eine Kühlvorrichtung mit den Merkmalen des Patentanspruchs 1 gelöst. Danach umfasst die erfindungsgemäße Kühlvorrichtung zum Kühlen von im Innern eines geschlossenen Gehäuses angeordneten elektrischen und/oder elektronischen Betriebsmitteln einen ersten geschlossenen Kühlkreislauf, der ein erstes Kühlmedium enthält zum Abtransport von Wärme, die im Betrieb von dem mindestens einem der Betriebsmittel erzeugt wird, aus dem Gehäuse heraus, wobei der erste Kühlkreislauf innerhalb des Gehäuses mit einem ersten Wärmeübertrager zum Übertragen der Wärme von dem mindestens einen Betriebsmittel auf das erste Kühlmedium und außerhalb des Gehäuses mit einem zweiten Wärmeübertrager zum Abgeben der Wärme an ein Außenkühlmedium verbunden ist, wobei der zweite Wärmeübertrager oberhalb des ersten Wärmeübertragers angeordnet ist und wobei der erste Kühlkreislauf, das erste Kühlmedium und der erste und zweite Wärmeübertrager ausgebildet sind, den Wärmetransport nach dem Zweiphasen-Thermosiphon-Prinzip zu realisieren.

Der Wärmetransport nach dem Zweiphasen-Thermosiphon-Prinzip erlaubt durch die Nutzung der Verdampfungswärme des Kühlmediums eine hohe Wärmestromdichte. Auf einer kleinen Querschnittsfläche können so große Verlust-Wärmemengen transportiert werden. Der Transport des Kühlmediums erfolgt generell passiv, d. h. ohne Hilfsmittel wie etwa eine Umwälzpumpe. Das Kühlmittel kreist lediglich aufgrund der Schwerkraft im Kühlkreislauf, wodurch sich eine niedrige Energiebilanz für die Kühlung ergibt. Somit kann die Kühlvorrichtung hohe Verlustleistungen bei einem wartungsarmen Aufbau abführen. Da mit diesem Kühlkonzept außer Rohrdurchführungen im Gehäuse keine weiteren Öffnungen notwendig sind, können hohe IP-Schutz arten, wie beispielsweise IP 65, einfach realisiert werden.

Eine vorteilhafte Ausgestaltung der Kühlvorrichtung ist durch die Merkmale des Anspruchs 2 gegeben. Danach ist der erste Wärmeübertrager als Kühlkörper ausgebildet zur wärmeleitenden Verbindung mit dem mindestens einen der Betriebsmittel. Der Wärmetransport von dem Betriebsmittel zum Kühlmedium erfolgt direkt durch Wärmeleitung über den Kühlkörper. Das Kühlmedium nimmt an der Oberfläche des Kühlkörpers die transportierte Wärme auf und verdampft dadurch.

Eine weitere vorteilhafte Ausgestaltung der Kühlvorrichtung ist durch die Merkmale des Anspruchs 3 gegeben. Danach ist der erste Wärmeübertrager zur Montage mindestens eines Leistungshalbleiters ausgebildet. Anwendung findet diese Ausgestaltung der Kühlvorrichtung bei Umrichterschränken mit hohen abzuführenden Verlustleistungen.

Eine besonders vorteilhafte Ausgestaltung der Kühlvorrichtung ist durch die Merkmale des Anspruchs 6 gegeben. Danach umfasst die Kühlvorrichtung einen zweiten geschlossenen Kühlkreislauf zum Kühlen von mindestens einem weiteren, im Innern des geschlossenen Gehäuses angeordneten elektrischen und/oder elektronischen Betriebsmittel, der ein zweites Kühlmedium enthält zum Abtransport von Wärme, die im Betrieb von dem mindestens einem weiteren der Betriebsmittel erzeugt wird, aus dem Gehäuse heraus, wobei der zweite Kühlkreislauf innerhalb des Gehäuses mit einem dritten Wärmeübertrager zum Übertragen der Wärme von dem mindestens einen weiteren Bauteil auf das zweite Kühlmedium und außerhalb des Gehäuses mit einem vierten Wärmeübertrager zum Abgeben der Wärme an das Außenkühlmedium verbunden ist, wobei der vierte Wärmeübertrager oberhalb des dritten Wärmeübertragers angeordnet ist und der zweite Kühlkreislauf, das zweite Kühlmedium und der dritte und vierte Wärmeübertrager ausgebildet sind, den Wärmetransport nach dem Zweiphasen-Thermosiphon-Prinzip zu realisieren. Der zweite Kühlkreislauf dient zum Kühlen von internen Betriebsmitteln, die im Betrieb andere thermische Randbedingungen einhalten müssen, als die Betriebsmittel, die über den ersten Kühlkreislauf entwärmt werden.

Eine weitere, besonders vorteilhafte Ausgestaltung der Kühlvorrichtung ist durch die Merkmale des Anspruchs 7 gegeben. Danach ist der dritte Wärmeübertrager ausgebildet, die mittels einer Luftströmung von dem mindestens einem weiteren Betriebsmittel zum dritten Wärmeübertrager transportierte Wärme an das zweite Kühlmedium zu übertragen. Insbesondere bei Betriebsmitteln mit nur geringen Verlustleistungen kann die im Betrieb erzeugte Wärme über die an deren Oberflächen vorbei streichende Luftströmung abgeführt werden. Damit ist ein besonders einfacher Aufbau des zweiten Kühlkreislaufs möglich.

Eine weitere vorteilhafte Ausgestaltung ist durch die Merkmale des Anspruchs 11 gegeben. Danach ist der dritte Wärmeübertrager mit einer im Gehäuse angeordneten Luftführung verbunden. Dadurch kann der Wärmetransport über die Luftströmung weiter erhöht werden.

Eine weitere besonders vorteilhafte Ausgestaltung ist durch die Merkmale des Anspruchs 12 gegeben. Danach bilden der zweite und vierte Wärmeübertrager eine bauliche Einheit zur Abgabe der transportierten Wärme an ein gemeinsames Kühlmedium. Damit werden alle Verlustleistungen über einen gemeinsamen externen Zweiphasen-Wärmetauscher aus dem geschlossenen Gehäuse abgeführt.

Die vorstehend beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung der Ausführungsbeispiele, die in Verbindung mit den Zeichnungen näher erläutert werden. Hierbei zeigen in schematischer Darstellung:
- FIG 1: in einer Seitenansicht geschlossenes Gehäuse mit zwei Kühlkreisläufen,
- FIG 2: das geschlossene Gehäuse nach FIG 1 in einer Frontansicht und
- FIG 3: eine Ausführung der externen Zweiphasen-Wärmetauscher mit Wasserkühlung.

Elektrische und elektronische Betriebsmittel oder Komponenten einer verfahrenstechnischen Anlage, einer Werkzeugmaschine oder Fertigungseinrichtung, die sich nicht direkt in der Maschine befinden (z.B. Sensoren), werden in separaten Gehäusen montiert und verschaltet. Dabei soll das Gehäuse den elektrischen und elektronischen Betriebsmitteln in seinem Innenraum Schutz vor Staub und Wasser bieten. Dazu sind die Gehäuse in Schutzarten oder IP-Schutzklassen eingeteilt. Zusätzlich bietet der Innenraum des Gehäuses Halt und Struktur für die Betriebsmittel. Eine geeignete Gehäuseklimatisierung bietet Schutz vor Überhitzung. Die Gehäuse können je nach Anforderung auch noch Schutz vor elektromagnetischer Beeinflussung (EMV), Schutz gegen mechanische Einflüsse, Vandalismus und Erdbeben bieten (beispielsweise durch die Verwendung von Gehäusen mit zusätzlichen Streben) und die Umgebung gegen elektromagnetische Emissionen abschirmen. Auch soll das Gehäuse ggf. Schutz gegen das Berühren gefährlicher Spannungen (Schutzklassen: Schutzerdung oder Schutzisolation) und Brandschutz (Speziallösungen für Entrauchungsanlagen) bieten. Im nachfolgend beschriebenen Ausführungsbeispiel ist der Fokus auf den Schutz der eingebauten Betriebsmittel vor Staub und Wasser sowie der Abführung der im Inneren des Gehäuses erzeugten Verlustwärme gerichtet.

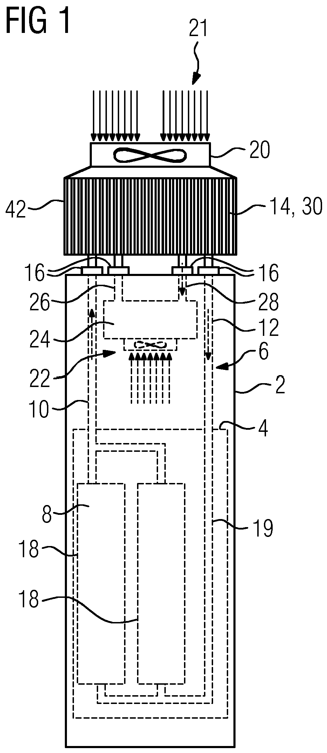

FIG 1 zeigt von der Seite im Schnitt ein geschlossenes Gehäuse 2, in dem elektrische und elektronische Betriebsmittel zur Ansteuerung eines elektrischen Antriebs (hier nicht dargestellt) montiert und elektrisch verschaltet sind. Das geschlossene Gehäuse 2 ist in Form eines Schaltschranks realisiert. Die elektrischen und elektronischen Betriebsmittel sind beispielsweise als Frequenzumrichter für Antriebsleistungen von mehreren 100 kW bis einigen Megawatt ausgebildet und entsprechend dimensioniert.

Damit der Frequenzumrichter (bzw. allgemein die elektrischen und elektronischen Betriebsmittel) auch unter erschwerten Umweltbedingungen über viele Jahre sicher arbeiten kann, ist das Gehäuse 2 gegen das Eindringen von Fremdkörpern und Wasser, auch verschmutztes Wasser, dicht ausgebildet. Die Eignung von elektrischen Betriebsmitteln für verschiedene Umgebungsbedingungen sowie zusätzlich der Schutz von Menschen gegen potentielle Gefährdung bei deren Benutzung wird durch die Schutzart festgelegt. Vorliegend soll das Gehäuse 2 beispielsweise mit einem Schutzgrad für Berührungs- und Fremdkörperschutz mindestens der Kennziffer "5" und mit einem Schutzgrad für Wasserschutz mindestens der Kennziffer "4" ausgebildet sein. Das Gehäuse kann auch ausgebildet sein, um bei Aufstellung im Freien den eingebauten Betriebsmitteln Schutz vor schädlichen Umwelteinflüsse zu bieten. Zur Erreichung derart hoher Schutzarten oder auch für Anwendungen im Freien ist auf den Abtransport der im Betrieb erzeugten Verlustwärme besonderes Augenmerk zu richten, wie nachfolgend noch detaillierter beschrieben ist.

Das Gehäuse 2 enthält ein Leistungshalbleitermodul oder auch Powermodul 4, das im Betrieb besonders hohe Verlustleistungen erzeugt. Zum Abtransport der im Betrieb erzeugten Verlustwärme, beispielsweise in der Größenordnung von 20 kW, ist das Powermodul 4 mit einem ersten geschlossenen Kühlkreislauf 6 verbunden.

Der Kühlkreislauf umfasst einen ersten Wärmeübertrager 8, der über eine Steigleitung 10 und eine Fallleitung 12 mit einem zweiten Wärmeübertrager 14 verbunden ist. Der zweite Wärmeübertrager 14 ist außerhalb des Gehäuses 2 und vertikal oberhalb des ersten Wärmeübertragers 8 angeordnet. Jeweils eine Durchführung 16 dichtet die Steigleitung 10 und die Fallleitung 12 gegenüber dem Gehäuse 2 ab. Der erste Wärmeübertrager 8 umfasst mehrere im Powermodul 4 integrierte Kühlkörper 18, auf denen wärmeleitend Leistungshalbleiter (hier nicht dargestellt) montiert sind. In dem Powermodul 4 sind die Steigleitung 10 und die Fallleitung 12 über integrierte Leitungen 19 mit den Kühlkörpern 18 verbunden.

Der Kühlkreislauf 6 ist mit einem Kühlmittel gefüllt und arbeitet nach dem Zweiphasen-Thermosiphon-Prinzip. Dabei wird die latente Verdampfungshitze des Kühlmittels genutzt, um die im Betrieb erzeugte Verlustwärme von den Kühlkörpern 18 zu dem zweiten Wärmeübertrager 14 zu transportieren. Die Anwendung des Zweiphasen-Thermosiphon-Prinzips erlaubt einen besonders einfachen Aufbau des Kühlkreislaufs 6 bei gleichzeitig hoher Wärmetransportleistung. Da die Temperatur des Kühlmittels bei der Anwendung des Zweiphasen-Thermosiphon-Prinzips nicht über die Verdampfungstemperatur ansteigen kann, können hier übliche Kühlmittel zum Einsatz kommen, die eine derartige Verdampfungstemperatur besitzen, dass im Betrieb die maximal zulässige Halbleitertemperatur nicht überschritten wird. Der Transport des Kühlmittels im Kühlmittelkreislauf 6 erfolgt ausschließlich über Gravitationskräfte, so dass keine zusätzlichen Kühlmittelpumpen für die Umwälzung des Kühlmittels benötigt werden.

Der zweite Wärmeübertrager 14 ist als Zweiphasen-Luft-Wärmetauscher ausgebildet und umfasst einen Ventilator 20 zum forcierten Wärmetransport an die Umgebung über die von dem Ventilator 20 erzeugte Luftströmung. Die Luftströmung durch den Wärmetauscher 14 soll durch Pfeile 21 angegeben werden. Wenn der Wärmetauscher 14 großzügig bezüglich des Wärmetransports dimensioniert ist, kann der Ventilator 20 ohne große Anforderungen hinsichtlich der Druckstabilität und Luftmenge ausgelegt werden. Es können dann beispielsweise Standardventilatoren oder Standardlüfter eingesetzt werden, wie sie auch für die Gebäudeklimatisierung verwendet werden.

In dem Gehäuse 2 ist ein zweiter Kühlkreislauf 22 angeordnet, der die Wärme aus dem Innern des Gehäuses 2 an die Umgebung ebenfalls mittels eines Kühlmittels nach dem Zweiphasen-Thermosiphon-Prinzip transportiert. Das Kühlmittel besitzt eine derartige Verdampfungstemperatur, dass im Betrieb die maximal zur Kühlung notwendige Lufttemperatur nicht überschritten wird.

Der zweite Kühlkreislauf 22 umfasst einen dritten Wärmeübertrager 24, der über eine Steigleitung 26 und eine Fallleitung 28 mit einem vierten Wärmeübertrager 30 verbunden ist. Der vierte Wärmeübertrager 30 ist außerhalb des Gehäuses 2 und vertikal oberhalb des dritten Wärmeübertragers 24 angeordnet. Die Steigleitung 26 und die Fallleitung 28 sind über Durchführungen 16 gegenüber dem Gehäuse 2 abgedichtet. Der interne dritte Wärmeübertrager 24 ist mit einem Ventilator 32 verbunden, der eine forcierte Luftströmung im Innern des Gehäuses 2 erzeugt, die durch Pfeile 21 charakterisiert ist.

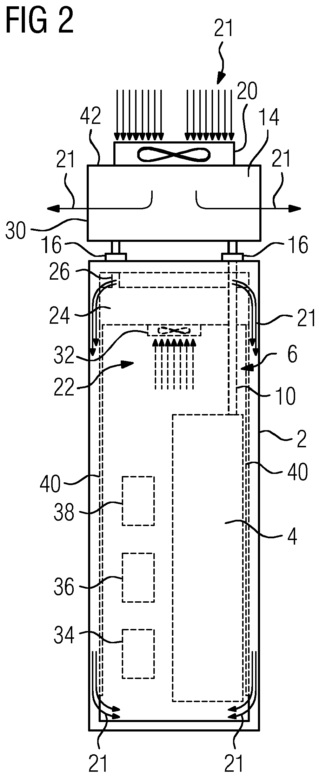

Der zweite Kühlkreislauf 22 dient der Entwärmung von weiteren im Innern des Gehäuses 2 angeordneten Betriebsmitteln, die nur eine geringe Verlustwärme abgeben und bei denen daher ein direkter Anschluss an einen Kühlkreislauf entbehrlich ist bzw. der Aufwand zum Anschluss an einen Kühlkreislauf in keinem vernünftigen Verhältnis zur abzuführenden Wärmemenge stünde. Dazu wird auf die in FIG 2 dargestellte Schnittzeichnung der Frontansicht des Frequenzumrichters Bezug genommen. Die Verlustwärme im Betrieb der weiteren Betriebsmittel besitzt eine niedrigere Verlustleistungsdichte als die Verlustleistungsdichte des Halbleitermoduls 4, so dass eine ausreichende Entwärmung über die forcierte Luftströmung erfolgen kann. Beispielhaft für die weiteren Betriebsmittel sind in FIG 2 ein Transformator 34, eine Kondensatorbaugruppe 36, eine Schalterbaugruppe 38 gezeigt. Es können jedoch weitere Betriebsmittel, die im Betrieb Wärme erzeugen, in das Gehäuse 2 eingebaut sein, beispielsweise Drosseln, Stromschienen, usw.

Um die Luftströmung an allen zu entwärmenden Betriebsmitteln entlang zu führen, ist eine Luftführung 40 vorgesehen. Die Luftführung 40 bildet Luftkanäle, in denen die entwärmte Luftströmung aus dem Bereich oberhalb des dritten Wärmeübertragers 24 in den unteren Bereich des Gehäuses 2 geführt ist. Die Luftströmung wird dabei durch die Luftführung 40 Seitenwänden des Gehäuses 2 nach unten geführt. Sie tritt im unteren Bereich des Gehäuses 2 wieder in den Innenraum des Gehäuses 2 ein. Auf dem Weg nach oben strömt die Luft im Innern des Gehäuses frei ohne weitere Luftführungselemente oder mit zusätzlichen Luftführungen (nicht dargestellt) und nimmt dabei die Verlustwärme der weiteren Betriebsmittel 34, 36, 38 auf. Die erwärmte Luft gibt dann ihre aufgenommene Wärme im dritten Wärmeübertrager 24 als Verdampfungswärme des Kühlmittels wieder ab.

Die externen Wärmeübertrager 14 und 30 des ersten und zweiten Kühlkreislaufs 6 und 22 sind vorzugsweise als bauliche Einheit in einem gemeinsamen Gehäuse 42 angeordnet. Der Ventilator 18 erzeugt in den beiden Wärmeübertragern 14 und 30 einen Luftstrom, über den die in den Kühlmitteln transportierte latente Wärme an die durchströmende Luft als Außenkühlmedium abgegeben wird.

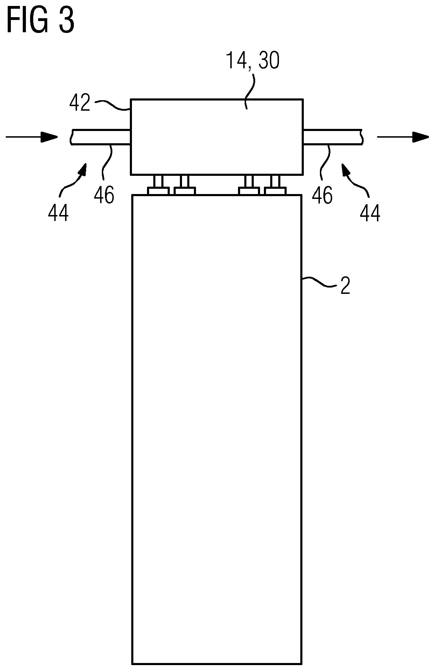

Eine alternative Ausführung der externen Wärmeübertrager 14, 30 zeigt schematisch FIG 3. Bei dieser Ausführungsform wird als Außenkühlmittel Wasser verwendet, welches von einem geschlossenen externen Wasser-Kühlkreislauf 44 geliefert wird. In FIG 3 sind nur eine Zufluss- und eine Abflussleitung 46 des externen Wasser-Kühlkreislaufs 44 zu den Wärmeübertragern 14, 30 gezeigt. Eine derartige Realisierung der Außenkühlung bietet sich an, wenn am Aufstellungsort schon ein Wasserkühlkreislauf für weitere zu kühlende Anlagenteile oder Betriebseinheiten existiert.

Die vorliegende Erfindung weist viele Vorteile auf. Insbesondere kann auf einfache und robuste Weise eine Kühlung von im Inneren von Gehäusen hoher Schutzart angeordneten, große Verlustleistungen erzeugenden elektrischen und elektronischen Betriebsmitteln erreicht werden.

Obwohl die Erfindung im Detail durch das bevorzugte Ausführungsbeispiel näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Kühlvorrichtung zum Kühlen von im Innern eines geschlossenen Gehäuses (2) angeordneten elektrischen und/oder elektronischen Betriebsmitteln (4,34,36,38) mit einem ersten geschlossenen Kühlkreislauf (6), der ein erstes Kühlmedium enthält zum Abtransport von Wärme, die im Betrieb von mindestens einem der Betriebsmittel (4) erzeugt wird, aus dem Gehäuse (2) heraus, wobei der erste Kühlkreislauf (6) innerhalb des Gehäuses (2) mit einem ersten Wärmeübertrager (8) zum Übertragen der Wärme von dem mindestens einen Betriebsmittel (4) auf das erste Kühlmedium und außerhalb des Gehäuses (2) mit einem zweiten Wärmeübertrager (14) zum Abgeben der Wärme an ein Außenkühlmedium verbunden ist, wobei der zweite Wärmeübertrager (14) oberhalb des ersten Wärmeübertragers (8) angeordnet ist und wobei der erste Kühlkreislauf (6), das erste Kühlmedium und der erste und zweite Wärmeübertrager (8,14) ausgebildet sind, den Wärmetransport nach dem Zweiphasen-Thermosiphon-Prinzip zu realisieren.

2. Kühlvorrichtung nach Anspruch 1 **dadurch ge - kennzeichnet**, dass der erste Wärmeübertrager (8) als Kühlkörper (18) ausgebildet ist zur wärmeleitenden Verbindung mit dem mindestens einen der Betriebsmittel (4).

3. Kühlvorrichtung nach Anspruch 1 oder 2, **dadurch gekennzeichnet, dass** der erste Wärmeübertrager (8) zur Montage mindestens eines Leistungshalbleiters ausgebildet ist.

4. Kühlvorrichtung nach einem der vorstehenden Ansprüche, **dadurch gekennzeichnet, dass** der zweite Wärmeübertrager (14) einen Ventilator (20) umfasst und ausgebildet ist, die transportierte Wärme an Luft als Außenkühlmedium abzugeben.

5. Kühlvorrichtung nach einem der Ansprüche 1 bis 3, **da** - **durch gekennzeichnet**, dass der zweite Wärmeübertrager (14) ausgebildet ist, die transportierte Wärme an einen geschlossenen Außenkühlkreislauf (44) abzugeben.

6. Kühlvorrichtung nach einem der vorstehenden Ansprüche, mit einem zweiten geschlossenen Kühlkreislauf (22) zum Kühlen von mindestens einem weiteren, im Innern des geschlossenen Gehäuses (2) angeordneten elektrischen und/oder elektronischen Betriebsmittel (34,36,38), der ein zweites Kühlmedium enthält zum Abtransport von Wärme, die im Betrieb von dem mindestens einem weiteren der Betriebsmittel (34,36,38) erzeugt wird, aus dem Gehäuse (2) heraus, wobei der zweite Kühlkreislauf (22) innerhalb des Gehäuses (2) mit einem dritten Wärmeübertrager (24) zum Übertragen der Wärme von dem mindestens einen weiteren Bauteil (34,36,38) auf das zweite Kühlmedium und außerhalb des Gehäuses (2) mit einem vierten Wärmeübertrager (30) zum Abgeben der Wärme an das Außenkühlmedium verbunden ist, dass der vierte Wärmeübertrager (30) oberhalb des dritten Wärmeübertragers (24) angeordnet ist und der zweite Kühlkreislauf (22), das zweite Kühlmedium und der dritte und vierte Wärmeübertrager (24,30) ausgebildet sind, den Wärmetransport nach dem Zweiphasen-Thermosiphon-Prinzip zu realisieren.

7. Kühlvorrichtung nach Anspruch 6, **dadurch ge** - **kennzeichnet**, dass der dritte Wärmeübertrager (24) ausgebildet ist, die mittels einer Luftströmung von dem mindestens einen weiteren Betriebsmittel (34,36,38) zum dritten Wärmeübertrager (24) transportierte Wärme an das zweite Kühlmedium zu übertragen.

8. Kühlvorrichtung nach Anspruch 6 oder 7, **dadurch gekennzeichnet, dass** der dritte Wärmeübertrager (24) einen Ventilator (32) umfasst.

9. Kühlvorrichtung nach einem der Ansprüche 6 bis 8, **da** - **durch gekennzeichnet**, dass der dritte Wärmeübertrager (24) oberhalb des mindestens einen weiteren Betriebsmittels (34,36,38) angeordnet ist.

10. Kühlvorrichtung nach einem der Ansprüche 6 bis 9, **da** - **durch gekennzeichnet**, dass der dritte Wärmeübertrager (24) im oberen Bereich des Gehäuses (2) angeordnet ist.

11. Kühlvorrichtung nach einem der Ansprüche 6 bis 10, **dadurch gekennzeichnet, dass** der dritte Wärmeübertrager (24) mit einer im Gehäuse (2) angeordneten Luftführung (40) verbunden ist.

12. Kühlvorrichtung nach Anspruch 6 bis 11, **dadurch gekennzeichnet, dass** der zweite und vierte Wärmeübertrager (14,30) eine bauliche Einheit (42) bilden zur Abgabe der transportierten Wärme an ein gemeinsames Kühlmedium.
